Europäisches Patentamt

European Patent Office

Office européen des brevets

(11) Publication number: **0 262 853**
**A1**

# EUROPEAN PATENT APPLICATION

(21) Application number: 87308376.0

(22) Date of filing: **22.09.87**

(51) Int. Cl.4: **H01L 27/10** , H01L 21/82

(30) Priority: **29.09.86 JP 230394/86**

(43) Date of publication of application:
**06.04.88 Bulletin 88/14**

(84) Designated Contracting States:
**DE FR GB**

(71) Applicant: **Matsushita Electronics Corporation**
**1006, Oaza-Kadoma Kadoma-shi**
**Osaka 571(JP)**

(72) Inventor: **Ohnuma, Makoto**
**Shousetsu-Ryou 35-22 Gungeshinmachi**
**Takatsuki-shi Osaka(JP)**

(74) Representative: **Crawford, Andrew Birkby et al**
**A.A. THORNTON & CO. Northumberland**
**House 303-306 High Holborn**
**London WC1V 7LE(GB)**

(54) Semiconductor device and method of making the same.

(57) A transistor of MIS type multigate structure is used in a ROM (read only memory) by disposing a threshold voltage controlling region under each gate and making use of the difference in the threshold voltage at the gates. The threshold voltage controlling region of one of the gate structures in such multigate structure is obtained by etching the semiconductor substrate (11), using the first gate structural part (14, 15) as the mask, to form a specified impurity diffusion layer (18) in the etched surface and by forming a second gate structural part (19, 20) thereon. Said first and second gate structural parts may be formed by self-matching method, and their positioning may be easy, so that the response to downsizing of parts may be improved, and a structure suited to higher degree of integration will be realized.

**Fig.3**

## SEMICONDUCTOR DEVICE AND METHOD OF MAKING THE SAME

This invention relates to a semiconductor device, more particularly, a MIS type multigate transistor and a ROM (Read only Memory) having this multigate transistors, and the method of making the same.

The threshold voltage of a MIS transistor can be controlled by the type and concentration of impurities diffused in the channel of it.

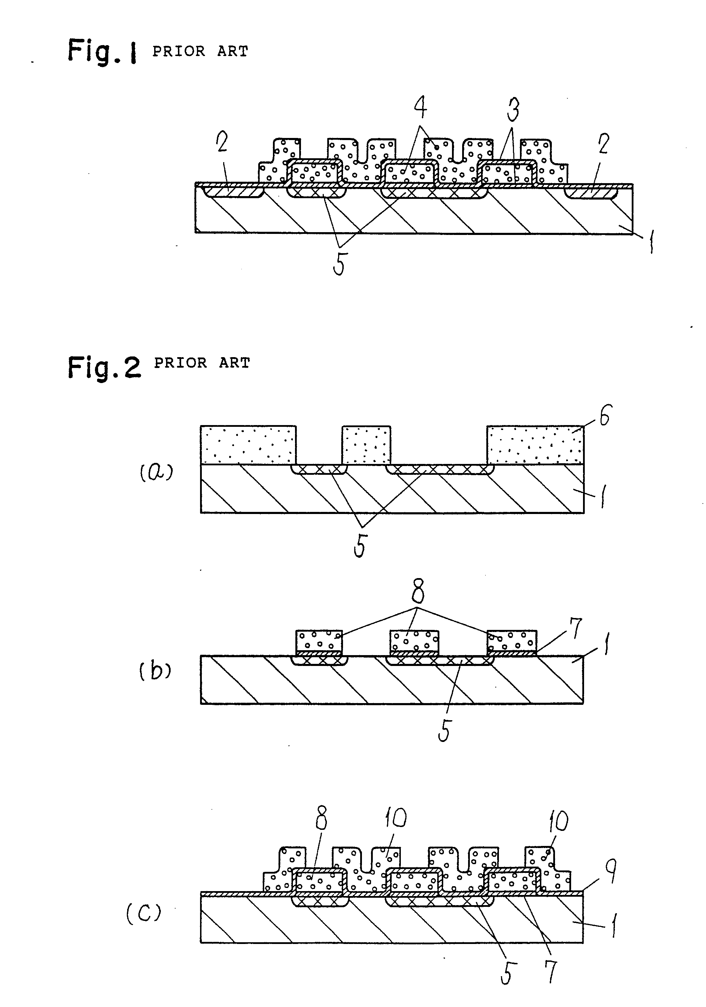

An example of a multigate transistor having the threshold voltage controlled by such impurities in channel is shown in Fig. 1.

In Fig. 1, numeral 1 designates a silicon semiconductor substrate, s designates the source or drain of a multigate transistor, 3 designates a silicon oxide film, 4 designates a polysilicon or polycide gate electrodes, and 5 designates an n type impurity diffusion layer diffued in order to make the channels beneath the gate electrode in the depletion type by controlling the threshold voltage of these channels. Channels without this impurity diffusion are of enhancement type.

As shown in Fig. 1, by selectively setting the channels beneath the individual gate electrodes of a multigate transistor in the depletion type or enhancement type, binary data, that is, "0" and "1", can be fixed.

Therefore, a ROM can be composed by using such multigate transistors.

A conventional manufacturing method of a multigate transistor forming a part of a mask ROM shown in Fig. 1 is described below while referring to the sectional views to show the process sequence in Fig. 2 (a) to (c).

First, as shown in Fig. 2 (a), on a silicon semiconductor substrate 1, a photoresist mask 6 for isolation of an n-type impurity diffusion region corresponding to a ROM code is formed, and n-type impurities are placed by ion implantation, thereby forming an n-type diffusion layer 5 for controlling the threshold voltage. Then, as shown in Fig. 2 (b), after forming a first gate oxide film 7 and a first polysilicon gate 8 by the known film forming technology and photolithography, a seocnd gate oxide film 9 and a second polysilicon gate 10 are formed similarly by the conventional technology as shown in Fig. s (c). Finally by forming a source and a drain, the structure shown in Fig. 1 is completed.

The prior arts are, for example, disclosed in the Japanese Laid-open Patent Sho. 57-120367 which is published on July 27, 1982 (Manufacturing method of MIS type semiconductor device for read only memory, Koda et al.,) and in a report "Characteristics of multigate transistor ROM", Koda et al., NTT Musashino Communications Laboratory (Electrocommunication Society Technical Report, 1979, pp. 17-24).

The semiconductor device is advanced in the direction of high integration of circuit and reduction of the size. Along with this trend, enhancement of precision of mask alignment in the lithographic process for forming the fine structure of semiconductor device is needed together with the structure of a semiconductor device having a wide margin for mask alignment.

If highly integrated by using the conventional MIS type multigate transistor structure, the alignment precision of the gate electrode to the n-type diffusion layer for controlling the threshold voltage notably influences the transistor characteristic, and it is hard to reduce the chip size. That is, in the case of the prior art, since the mask pattern of memory information and polysilicon electrode pattern are not self-aligned, there is a very narrow margin for mask alignment, and the degree of high integration of circuit and reduction of size is limited by the mask alignment precision of the mask aligner.

## SUMMARY OF THE INVENTION

It is hence a primary object of this invention to present an effective means for downsizing the semiconductor device of MIS type multigate structure.

It is another object of this invention to establish a technical means (method) for realizing the threshold voltage controlling region of each gage by self-aligning, in a semiconductor device of MIS type multigate structure.

To realize these and other objects, this invention is characterized by the steps of, in forming channels of MIS type transistor, forming a first impurity diffusion layer and first gate electrodes, etching partially exposed parts of said first impurity diffusion layer and semiconductor substrate other than the channel portion beneath said first gate electrode, forming a second impurity diffusion layer from this etching surface, and forming a second gate structure on said second impurity diffusion layer.

By this constitution, position alignment in formation of gate electrode to the impurity diffusion layer in the channel portion of the MIS transistor may be executed by self-aligning technology, and the margin of this position matching may be extended, which makes it easier to produce in a fine structure.

While the novel features of the invention are set forth with particularity in the appended claims, the invention, both as to organization and content, will be better understood and appreciated, along with other objects and features thereof, from the following detailed description taken in conjunction with the drawings.

## BRIEF DESCRIPTION OF THE DRAWINGS

Fig. 1 shows a structure of a multigate transistor used in a conventional mask ROM;

Fig. 2 shows a manufacturing process of a conventional multigate transistor; and

Fig. 3 shows a manufacturing process of a multigate transistor used in a mask ROM in one of the embodiments of this invention.

## DETAILED DESCRITPION OF THE INVENTION

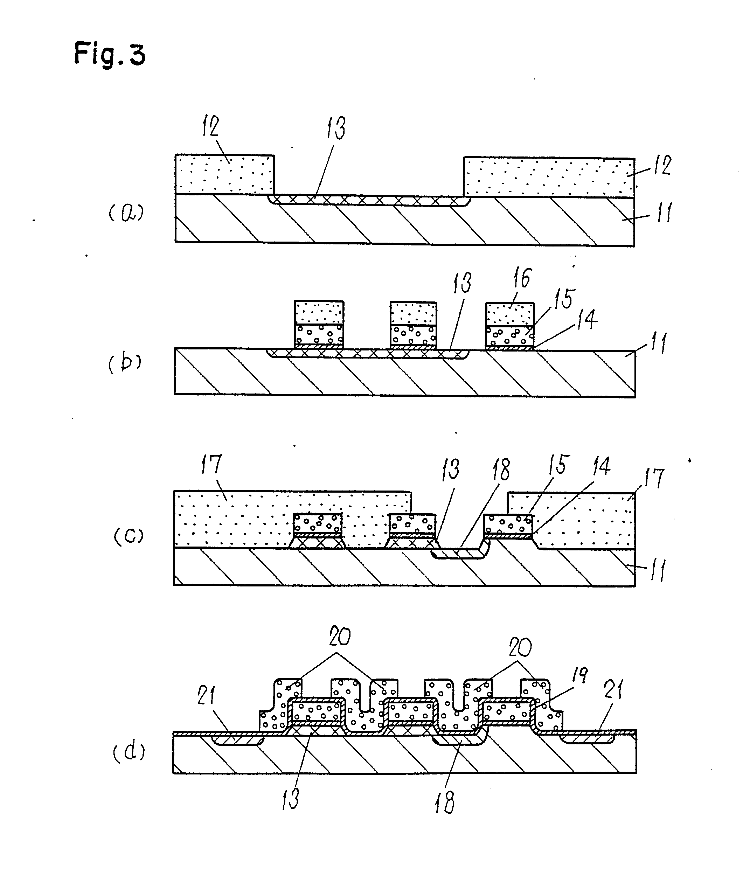

One of the embodiments of this invention is described below according to the process flow sectional drawings in Fig. 3 a to d. First, B (boron) ion is implanted to the principal plane of a p-type silicon substrate for control of the threshold voltage of the first gate enhancement transistor. Then as shown in Fig. 3 a, a first photoresist mask 12 is formed on the principal plane of a p-type silicon substrate 11 by photolithography, and arsenic As + or phosphorus P + ions are implanted for control of the threshold voltage of the first gate, and an n-type diffusion layer 13 for controlling the first gate threshold voltage is formed.

Next, as shown in Fig. 3 b, a first gate oxide film 14 is formed in a high temperature oxidizing atmosphere, and a first polysilicon or polycide 15 is formed thereon CVD process, and they are formed, by etching, into specified patterns of the first polysilicon 15 and first gate oxide film 14, according to the pattern of a second photoresist mask 16 in the photolithographic process. Then, using the second photoresist mask 16 as the mask, the impurity diffusion layer 13 and the silicon substrate 11 are etched in a thickness so that the n-type diffusion layer 13 other than the portion immediately beneath said mask may be removed.

In consequence, as shown in Fig. 3 C, a third photoresist mask 17 is formed in the photolithographic process, and As + or P + ions are implanted for control of the second gate threshold voltage, so that an n-type diffusion layer 18 for controlling the second gate threshold voltage is formed. After that, the third photoresist mask 17 is removed, and B (boron) ion is implanted to the principal plane of the silicon substrate including the first gates 15 and n-type diffusion layer 18 for control of the threshold voltage of the second gate enhancement transistor. Of course, the B ion may be implanted before forming the third of photoresist mask 17. Afterwards, as shown in Fig. 3 d, a second gate oxide film 19 is formed in a high temperature oxidizing atmosphere, and a second polysilicon or polycide 20 is formed thereon by CVD process, and a polysilicon electrode of the second gate is formed by the steps of patterning by photolithography and etching of the second polysilicon 20. Finally, by forming source and drain 21, a multigate transistor having the binary information fixed is completed.

As shown in Fig. 3 d, a multigate transistor completed using above process has a special structural feature as follows.

(1) A semiconductor substrate has a plurality of protrusions.

(2) A plurality of first gate insulation films and first gate electrodes are disposed on the top of the protrusions.

(3) At least one protrusion of the semiconductor substrate is diffused by impurities.

(4) A surface of the semiconductor substrate side walls of the protrusions, side walls and top surface of the gate electrode are covered by second insulation film.

(5) A plurality of second gate electrode are disposed on the second insulation film which is located between the protrusions.

According to the experience obtained from this embodiment, for example, when the width of the first gate electrode and second gate electrode was respectively 1.0 $\mu$m, the positioning margin of the mask to form the first gate electrode to the first impurity diffusion layer could be extended up to 0.5 $\mu$m in its widthwise direction. This is because the deviated portion of the first impurity diffusion layer 13 caused by slight dislocation of the mask is etched off by etching process, and the width of the first impurity diffusion layer 13 can be set somewhat broader since it will be finally etched off. Meanwhile, the second gate electrode is formed by self-align method as same as the first gate electrode. Therefore, as to the second gate electrode, the same effects are expected.

According to this invention, the positioning margin of the gate electrode to the n-type impurity diffusion layer of the channel portion of MIS type multigate transistor is enhanced, and does not depend so much on the matching precision of the mask aligner, and it is possible to manufacture in a fine structure, so that a superlarge capacity memory device may be fabricated easily.

Meanwhile, this invention may be applied not only to the mask ROM, but also to the ROM for writing programs in a microcomputer and others. Moreover, not limited to the memory device, it may be widely applied, needless to say, for controlling the threshold voltage of MIS type transistor of multigate semiconductor device.

While specific embodiments of the invention have been illustrated and described herein, it is realized that modifications and changes will occur to those skilled in the art. It is therefore to be understood that the appended claims are intended to cover all modifications and changes as fall within the true spirit and scope of the invention.

## Claims

1. A semiconductor device comprising:
a first impurity diffusion layer disposed in a selective region on a semiconductor substrate;
at least one of first gates composed of a first gate insulation films and a first gate electrodes disposed on said first impurity diffusion layer;
a concave of said semiconductor substrate disposed adjacent to said first gate;
a second impurity diffusion layer disposed at said concave;
and at least one of second gates composed of a second gate insulation films and second gate electrodes disposed on said second impurity diffusion layer.

2. The semiconductor device according to claim 1, wherein a depth of said concave of the semiconductor substrate is equal to or greater than the thickness of the first impurity diffusion layer.

3. The semiconductor device according to claim 1, wherein said first impurity diffusion layer and the second impurity diffusion layer contains samd impurities.

4. The semiconductor device according to claim 1, wherein said first impurity diffusion layers contain first impurity element and said second impurity diffusion layers contain second impurity element.

5. The semiconductor device according to claim 3, wherein said impurities are arsenic or phosphorus ions.

6. A method of making a semiconductor device comprising a steps of:
forming at least one of first impurity diffusion layers in predetermined region of a semiconductor substrate;
forming a plurality of first gate insulation films and a plurality of first gate electrodes on said first impurity diffusion layer and said semiconductor substrate;
etching away selectively said first impurity diffusion layer and/or said semiconductor substrate by using said plural first gate electrodes as a mask, thereby concaves are formed in said semiconductor substrate;
forming,when necessary, a second impurity diffusion layer in at least one of said concaves; and
forming a plurality of second gate insulation films and a plurality of second gate electrodes on said concaves.

7. The method according to claim 5, wherein the second impurity diffusion layer is formed by self-alignment by ion implantation, using the first gate electrodes as a mask.

8. The method according to claim 5, wherein a depth of selectively etching said semiconductor substrate is equal to or greater than a thickness of said first impurity diffusion layer.

9. The method according to claim 5, wherein concaves formed by selectively etching said semiconductor substrate are present in a plurality, and said second gate insulation films and said second gate electrodes are formed on individual said concaves.

10. A multigate transistor comprising:
a plurality of protrusions formed on a semiconductor substrate;
first insulation films formed on the top of said protrusions;
first gate electrodes formed on said first insulation film on the protrusions;
a second insulation film formed on the side and top of said first gate electrode and surface of said semiconductor substrate;
second gate electrodes formed on said second insulation film located on said semiconductor surface.

11. The multigate transistor according to claim 9, wherein at least one of said protrusions is diffused by impurities.

**Fig. 1** PRIOR ART

**Fig. 2** PRIOR ART

(a)

(b)

(c)

# Fig. 3

(a)

12    13    12    11

(b)

13   16   15   14   11

(c)

17   13   18   15   14   17   11

(d)

20   20   19   21   21   13   18

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IBM TECHNICAL DISCLOSURE BULLETIN, vol. 23, no. 6, November 1980, pages 2245-2246, New York, US; E. ADLER: "Self-aligned, ion-implanted read-only memory" * Whole document * | 1-4,6-11 | H 01 L 27/10 H 01 L 21/82 |
| A | US-A-4 328 563 (P.R. SCHROEDER) * Figures 3-9; column 2, line 42 - column 3, line 43 * | 1-11 | |

TECHNICAL FIELDS SEARCHED (Int. Cl.4)

H 01 L 27
H 01 L 29
H 01 L 21

The present search report has been drawn up for all claims

| Place of search | Date of completion of the search | Examiner |
|---|---|---|
| THE HAGUE | 13-11-1987 | MOENS R.H. |

EPO FORM 1503 03.82 (P0401)